**Europäisches Patentamt**

**European Patent Office**

**Office européen des brevets**

(19)

(11) Veröffentlichungsnummer: **0 090 321**
A2

(12) # EUROPÄISCHE PATENTANMELDUNG

(21) Anmeldenummer: **83102810.5**

(22) Anmeldetag: **22.03.83**

(51) Int. Cl.³: **C 01 B 33/02, C 23 C 11/00**

(30) Priorität: **29.03.82 IT 4811382**

(43) Veröffentlichungstag der Anmeldung: **05.10.83**
**Patentblatt 83/40**

(84) Benannte Vertragsstaaten: **DE FR GB IT NL**

(71) Anmelder: **DYNAMIT NOBEL AKTIENGESELLSCHAFT, Patentabteilung Postfach 1209, D-5210 Troisdorf, Bez. Köln (DE)**

(72) Erfinder: **Amaduzzi, Romano, P.zza S. Vigilio, 13, Merano (IT)**
Erfinder: **Curatolo, Luigi, C.so Libertà, 192, Merano (IT)**
Erfinder: **Scandola, Pietro, Via Vogelweide, 23, Merano (IT)**

(54) Reaktor und Verfahren zur Herstellung von Halbleitersilicium.

(57) Vorliegende Erfindung behandelt ein Verfahren zur Herstellung von Halbleitermaterial, vorzugsweise Silicium und einen Reaktor zur Durchführung dieses Verfahrens, bei dem ein Gemisch aus gasförmigen Verbindungen dieses Halbleitermaterials und Wasserstoff auf einem Trägermaterial, das auf die Zersetzungstemperatur dieser gasförmigen Verbindungen erhitzt ist, thermisch zersetzt wird. Das Trägermaterial liegt in Form dünner Stäbe vor; es befindet sich innerhalb einer Vorrichtung mit einer kühlbaren metallischen Grundplatte und einer Glocke mit einer äußeren und inneren Wand. Zwischen diesen Wänden zirkuliert eine Kühlflüssigkeit. Die Verbesserung besteht darin, daß die Grundplatte und die Glocke aus rostfreiem Stahl hergestellt sind, dessen innerere Oberfläche spiegelblank poliert ist. Das bevorzugte Kühlmedium ist ein Wärmeübertragungsöl.

Troisdorf, den 18. März 1983
OZ 82015 Dr.Sk/Bd

DYNAMIT NOBEL AKTIENGESELLSCHAFT
Troisdorf Bez. Köln

Verfahren und Vorrichtung zur Abscheidung von hochreinem
Halbleitermaterial

Vorliegende Erfindung betrifft ein Verfahren und eine entsprechende Vorrichtung zur Abscheidung von hochreinem
Halbleitermaterial mittels thermischer Zersetzung von gasförmigen Verbindungen dieses Halbleitermaterials, oder
von Gemischen mit verschiedenen dieser gasförmigen Verbindungen, auf Trägerkörpern, die durch einen elektrischen
Strom auf die Zersetzungstemperatur dieser Verbindungen erhitzt werden.

Dieses bekannte Verfahren, das hauptsächlich für die Abscheidung von Halbleitersilicium eingesetzt wird, wird
gemäß dem bekannten Stand der Technik in Reaktionsgefäßen
durchgeführt, die bestehen aus einer wassergekühlten,
metallischen Grundplatte, durch die ein oder mehrere Paare
von elektrischen Zuleitungen hindurchgehen, und einer Quarzglocke, die von einer Glocke aus rostfreiem Stahl umgeben
ist, deren Aufgabe es ist, daß die Glocke den im Reaktionsraum herrschenden Innendruck standhält und daß ein

0090321

hermetischer Verschluß zu der Grundplatte vorliegt. Die Grundplatte enthält ferner Befestigungsvorrichtungen für die Trägerkörper und Rohrverbindungen für die Zu- und Ableitungen der gasförmigen Verbindungen. Über der genannten ersten Kappe befindet sich noch eine zweite Kappe aus rostfreiem Stahl, wobei der Zwischenraum zwischen den beiden Kappen als Raum für das Kühlmedium dient und Teil der gesamten Kühlvorrichtung ist, in der Wasser als Kühlflüssigkeit dient.

Bei der Herstellung von Siliciumstäben, d.h. der gebräuchlichsten Form von Silicium für elektronische Zwecke, sind ein oder mehrere Paare von dünnen Siliciumstäben senkrecht auf der Grundplatte am oberen Ende der entsprechenden Stromdurchführungsleitungen befestigt. Die oberen Ende der Stäbe jedes Paares sind durch eine Brücke aus Silicium oder Graphit miteinander verbunden, so daß jedes Paar einen elektrischen Stromkreis in Form eines umgekehrten U bildet.

Sobald der Reaktionsraum verschlossen ist, wird für die Durchführung der Abscheidung das System abgedichtet und gereinigt. Anschließend werden die Stäbe auf die Zersetzungstemperatur der Siliciumverbindungen erhitzt und daraufhin diese Verbindungen in den Reaktionsraum eingeschleust. Auf der Oberfläche der Siliciumstäbe scheidet sich dann das Silicium kontinuierlich bis zu der gewünschten Enddicke ab.

Die zur Zeit zur Verfügung stehenden Quarzhauben besitzen Durchmesser, die nicht größer als etwa 900 mm sind und ihre maximale Höhe beträgt nicht mehr als 2500 mm; die Wanddicke liegt nicht unter 15 bis 20 mm. Diese Abmessungen bewirken Nachteile für den Reaktor und das Abscheideverfahren:

0090321

Aufgrund der großen Empfindlichkeit von solchen Quarzglocken gegenüber wiederholter thermischer Belastung und hohen Temperaturstößen, die durch die Durchführungs-Cyklen bedingt sind, ist deren Lebensdauer recht kurz; dies bedingt folglich hohe Verfahrenskosten.

Weiterhin ist es notwendig, die Fließrate und das molare Verhältnis der Mischung aus gasförmigen Siliciumverbindungen und Wasserstoff und die Temperatur der ständig wachsenden Siliciumstäbe unterhalb bestimmter Grenzen zu halten, die nicht geeignet sind, optimale Abscheidungen und Ausbeuten bei diesem Verfahren zu erhalten. Ein Überschreiten der bestehenden Grenzen verursacht ungewünschte Abscheidung von Silicium an der inneren Oberfläche der Wände der Quarzglocke, weil in solchen Fällen diese Wände oft nicht mehr genügend kühl gehalten werden können, um eine Abscheidung zu verhindern.

Es bestand deshalb die Aufgabe, einen Reaktor und ein Verfahren aufzufinden, die diese genannten Nachteile nicht aufweisen.

In Erfüllung dieser Aufgabe wurde nun ein Verfahren zur Herstellung von Halbleitermaterial und einen Reaktor zur Durchführung dieses Verfahrens mit dem im Oberbegriff der Ansprüche 1 und 6 genannten Merkmalen gefunden, die dadurch gekennzeichnet sind, daß anstelle der Quarzglocke eine Glocke aus rostfreiem Stahl vorhanden ist, und daß die Oberfläche der inneren Wand des Reaktionsraums spiegelblank poliert ist.

Zwar werden in der US-PS 4 173 944 auch schon Reaktoren für die Herstellung von Halbleitersilicium beschrieben, die ebenfalls keine Quarzglocke besitzen. Bei diesen besteht die Reaktorhaube aus einem Stahl, dessen innere Oberfläche mit Silber beschichtet ist. Die Silberbeschichtung des Stahls, die in diesem Schutzrecht beschrieben ist, wird in einem Mehrstufen-Verfahren durchgeführt; Aus diesem Grunde ist die Herstellung der in dieser Patentschrift genannten Hauben außerordentlich zeitraubend und aufwendiger als die Herstellung der erfindungsgemäßen Hauben.

Die Grundplatte und auch die Reaktorhaube werden aus Metall, vorzugsweise aus einer korrosionsbeständigen Legierung hergestellt. Geeignete Legierungen, die eingesetzt werden können, sind an sich bekannt. Besonders geeignet sind Stahltypen entsprechend DIN X2 CrNi Mn 1810 oder AISI 316 L. Auch andere Stahltypen aus der Gruppe URANUS[R] und HASTELLOY[R], wie z.B. Uranus B 6 oder Hastelloy B können verwendet werden.

Das Polieren der Oberfläche dieser Stahlsorten wird nach allgemein bekannten Verfahren durchgeführt. Die Oberfläche soll in der Weise poliert werden, daß sie die Bedingungen von ASTM A 40, Condition 8, erfüllen. Die so behandelte Oberfläche reflektiert dann die Strahlungshitze effektiver als eine unpolierte Oberfläche.

Die Reaktorhaube ist mit einem oder mehreren Kühlmänteln versehen. Das gesamte Reaktorsystem ist so konstruiert, daß es einem Innendruck bis zu 25 bar standhält. Innerhalb der Grundplatte sind Kühlkanäle und Durchbohrungen für die Stromzuführung und die Halteelemente der Abscheidungsstäbe vorgesehen.

Trotz des Fehlens der thermisch isolierenden Quarzwände läßt sich die Oberflächentemperatur der Reaktorwände zum Reaktorinneren hin leicht innerhalb der Grenzen von 50 bis 300°C halten. Dies erfolgt weiterhin mittels eines geeigneten Kühlmittels, das in den Kühlmänteln zirkuliert. Die Kühlmittel sollen Siedepunkte oberhalb des Siedepunkts von Wasser besitzen. Das bevorzugte Kühlmittel ist ein Wärmeübertragungsöl.

Innerhalb der genannten Temperaturgrenzen der Reaktorwände findet keine Abscheidung von Silicium an diesen Wänden statt. Gelegentlich auftretende Abscheidungen von polymeren Neben-produkten, die bei dem Verfahren der Abscheidung von Siliciumverbindungen auftreten, stören den Prozeß nicht oder sind für die Apparaturen nicht gefährlich. Sogar bei den folgenden extremen Reaktionsbedingungen, die sich als besonders geeignet für das erfindungsgemäße Abscheideverfahren erwiesen haben, lassen sich die genannten Nachteile vermeiden: Temperatur der Abscheidungsstäbe bis 1200°C, im allgemeinen zwischen 1000 und 1250°C, Molverhältnis von Siliciumverbindungen zu Wasserstoff bis zu 1,0, Durchfluß-menge der Siliciumverbindungen oder der diese enthaltenden Gemische pro Volumeneinheit des Reaktorraums bis zu 300 kg/h.m$^3$ und ein Reaktionsdruck bis zu 10 bar.

Ein weiterer Vorteil, der sich aus dem Wegfall der Quarzglocke als Reaktorhaube ergibt, liegt darin, daß erfindungsgemäß der Reaktor in beliebiger Größe und Form ausgebildet werden kann. Dadurch ist es beispielsweise möglich, daß die Abscheidungsstäbe in beliebiger Größe und Anzahl, z.B. acht, zwölf oder noch mehr, innerhalb des Reaktors angeordnet werden können. Die Anordnung der Stäbe innerhalb des Reaktors erfolgt dabei vorzugsweise in an sich bekannter Weise, z.B. paarweise symmetrisch der Längsachse des Reaktors.

Die erfindungsgemäße Apparatur und das darin durchgeführte Verfahren ermöglicht eine längere Lebensdauer dieser Vorrichtung im Vergleich zu den bisher für den gleichen Zweck benutzten Quarzglocken als Reaktorhauben. Weiterhin wird eine höhere Abscheidungsquote und eine höhere Ausbeute

0090321

erzielt aufgrund der erfindungsgemäßen möglichen höheren Verfahrenstemperatur der Abscheidungsstäbe, des höheren Molverhältnisses von Siliciumverbindungen zu Wasserstoff und der höheren Durchflußrate der Verbindungen des Halbleitermaterials pro Reaktionsvolumen. Diese Vorteile ergeben zusammengenommen geringere Verfahrens- und Unterhaltungsprobleme, keine ungewünschte Abscheidung polymerer Siliciumverbindungen an den inneren Reaktorwänden, keinen Verlust von ungewünscht abgeschiedenen Silicium auf den Innenwänden und eine Reduzierung des elektrischen Energieverbrauchs pro kg abgeschiedenen Siliciums von den bisherigen Standardwerten, die bis zu 200 bis 250 kWh/kg lagen, auf etwa 70 bis 80 kWh/kg oder noch geringere Werte.

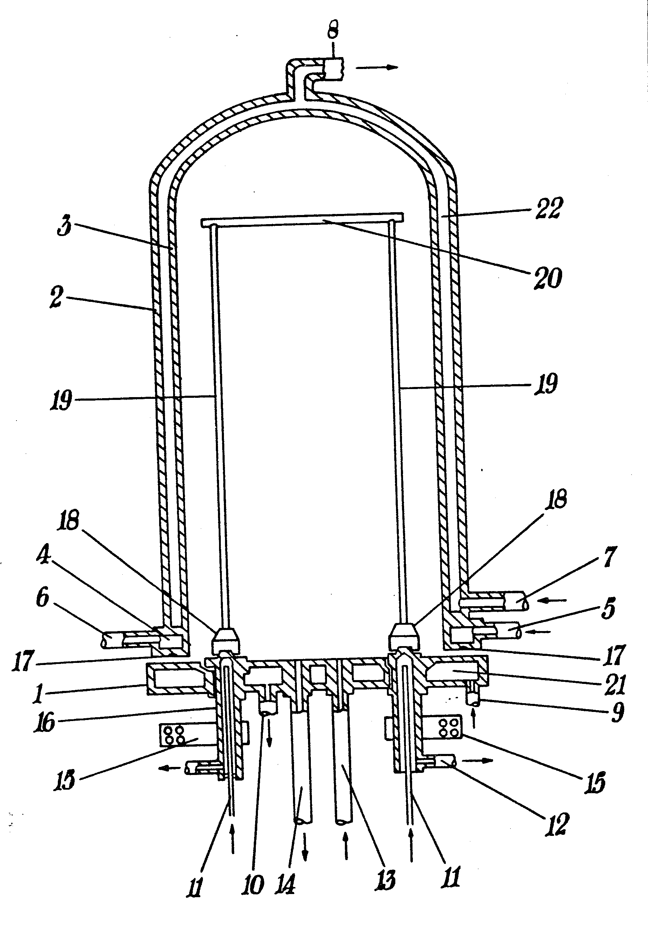

Figur 1 zeigt eine erfindungsgemäße Durchführungsform des beanspruchten Reaktors:

Der Reaktionsraum besteht aus der Grundplatte 1 und der glockenförmigen Haube 2. Die Grundplatte ist aus einer korrosionsbeständigen Legierung, deren zum Reaktorinneren gekehrte Oberfläche spiegelblank poliert ist; sie ist von einem Labyrinth von Kühlräumen 21 innerhalb ihrer Gesamtfläche durchzogen und mit zwei kurzen Rohren 9 und 10 verbunden, die als Ein- und Ausgang für das Kühlmedium, vorzugsweise einem natürlichen oder synthetischen Wärmeübertragungsöl, dienen.

Durch die Grundplatte führen zwei Rohre 13 und 14 als Ein- und Ausgang für die Reaktionsgase.

Weiterhin führen durch die Grundplatte einige Paare von Stromzuführungen 16, die durch ein Kühlmedium gekühlt werden, das durch die Zuführungen 11 einfließt und über die Abführungen 12 ausfließt. Die Stromzuführungen sind mit Energieanschlüssen 15 verbunden; an ihnen werden auch die Befestigungsblöcke 18 aus Graphit, an denen die Siliciumstäbe 19 befestigt sind, in aufrechter Stellung zum Reaktorinneren festgehalten.

Die Glocke besteht aus zwei konzentrisch verlaufenden Umhüllungen, deren innere 3 aus einer korrosionsbeständigen Metall-Legierung mit einer spiegelblank polierten inneren Oberfläche besteht; die äußere Umhüllung 2 besteht aus einem normalen rostfreien Stahl. Zwischen diesen Umhüllungen befindet sich der Kühlmantel 22. Die Kühlflüssig-keit, z.B. das Wärmeübertragungsöl, fließt in den Kühlmantel bei der Einführung 7 ein und tritt an Ausgang 8 aus, der am oberen Ende der Haube angeordnet ist. Einführung 7 und Ausgang 8 sind mit einem - hier nicht gezeigten - außen verschlossenen System verbunden, in dem die Temperatur kontrolliert und geregelt wird.

Der am Boden der Haube findliche Flansch, in dem die aus elastomeren PTFE hergestellten Dichtungen 17 für die Verbindung zwischen Grundplatte und Haube angeordnet sind, hat ein getrenntes ringförmiges Kühlsystem mit Einlaß 5 und Austritt 6.

Zwölf undotierte, hochreine Siliciumstäbe 19 mit einem Querschnitt von etwa 0,45 cm$^2$ und 200 cm Länge sind auf den Verbindungsblöcken 18 der Grundplatte befestigt und an ihren oberen Enden durch Siliciumbrücken 20 miteinander verbunden. Zwei Stabpaare sind jeweils miteinander verbunden und bilden, zusammen mit den äußeren Verbindungen, einen elektrischen Dreiphasenstromkreis mit Sternschaltung.

Zur Durchführung des Verfahrens innerhalb dieses Reaktors wird die Glocke, die einen inneren Durchmesser von 800 mm und eine Höhe von 2250 mm besitzt, auf die Grundplatte aufgesetzt, fest mit dieser verbunden, anschließend der Reaktionsraum mehrmals ausgespült und dann die Stäbe 19 auf 1120°C erhitzt und angeätzt. Daraufhin wird das aus Trichlorsilan und Wasserstoff im Molverhältnis 0,2 bestehende Reaktionsgas in den Reaktionsraum eingeleitet.

Die Fließgeschwindigkeit, bezogen auf Trichlorsilan, erreichte bei Durchführung dieser Verfahrensweise im vorliegenden Beispiel maximal 290 kg/h. Der Durchschnitt lag bei 260 kg/h. Der Druck im Reaktionsraum betrug 5 bar. Ingesamt wurde während 90 Stunden durchgehend Silicium abgeschieden. Dabei wurden 390 kg polykristallines Silicium bei einem Energieverbrauch von 70 kWh/kg hergestellt.

Troisdorf, den 18. März 1983
OZ 82015 Dr.Sk/Bd

<u>Patentansprüche</u>

1. Verfahren zur Herstellung von reinem Halbleitermaterial, vorzugsweise Silicium, durch thermische Zersetzung gasförmiger Verbindungen dieses Halbleitermaterials auf der Oberfläche dünner Stäbe dieses Halbleitermaterials, die mit Hilfe eines elektrischen Stroms, der durch diese Stäbe hindurchfließt, auf die Zersetzungstemperatur der gasförmigen Verbindungen erhitzt werden, und wobei der Reaktionsraum, in dem die dünnen Stäbe angeordnet sind, umschlossen wird von einer Grundplatte, die Hohlräume für eine Kühlflüssigkeit aufweist und einer damit fest verbundenen doppelwandigen Glocke mit einem Kühlmantel, d a d u r c h   g e k e n n z e i c h n e t , daß die gasförmigen Verbindungen mit einer Durchflußgeschwindigkeit bis zu 300 kg/h pro Volumeneinheit ($m^3$) des Reaktionsraums und einer Zersetzungstemperatur der dünnen Stäbe von 1000 bis 1250°C in den Reaktionsraum strömen, dessen Wände aus einer korrosionsfesten Legierung bestehen, deren innere Oberfläche spiegelblank poliert ist.

2. Verfahren gemäß Anspruch 1, dadurch gekennzeichnet, daß bei einem Druck von 5 bis 10 bar innerhalb des Reaktionsraums gearbeitet wird.

3. Verfahren gemäß Ansprüchen 1 und 2, dadurch gekennzeichnet, daß das zu zersetzende Gas ein Gemisch aus Wasserstoff und Trichlorsilan, das teilweise oder vollständig durch Siliciumtetrachlorid und/oder Dichlorsilane ersetzt sein kann, ist wobei das Molverhältnis von Chlorsilanen zu Wasserstoff bis zu 1,0 betragen kann.

0090321

4. Verfahren gemäß Anspruch 1, dadurch gekennzeichnet, daß Grundplatte und Glocke auf Temperaturen zwischen 50 und 300°C mittels hochsiedender Flüssigkeiten, die durch den Kühlmantel der Glocke und die Hohlräume der Grundplatte fließen, gekühlt werden.

5. Verfahren gemäß Anspruch 4, dadurch gekennzeichnet, daß die Kühlflüssigkeit ein Wärmeübertragungsöl ist.

6. Vorrichtung zur Herstellung von reinem Halbleitermaterial, vorzugsweise Silicium, durch Zersetzung gasförmiger Verbindungen dieses Halbleitermaterials auf der Oberfläche von dünnen Stäben desselben Materials, die auf die Zersetzungstemperatur der Verbindungen mittels eines elektrischen Stroms, der durch die dünnen Stäbe fließt, erhitzt werden, bei der der Reaktionsraum begrenzt wird von einer Grundplatte mit Hohlräumen für eine Kühlflüssigkeit und einer doppelwandigen Glocke, die mit einem Kühlmantel verbunden ist, dadurch gekennzeichnet, daß die Glocke und die Grundplatte aus einer korrosionsbeständigen Legierung hergestellt sind, wobei die inneren Oberflächen dieser Grundplatte und dieser Glocke spiegelblank poliert sind.